# EUROPEAN PATENT APPLICATION

(11) **EP 2 665 095 A1**
(43) Date of publication of application: **20.11.2013**
(21) Application number: 12168342.9
(22) Date of filing: 16.05.2012
(51) Int. Cl.: H01L 25/11, H01L 23/043, H01L 23/051, H01L 23/44

(54) **Power electronic devices**

(71) Applicant: GE Energy Power Conversion UK Limited, Rugby Warwickshire CV21 1BU (GB)
(72) Inventor: Goldney, Andrew Peter, Crick, Northamptonshire NN6 7TS (GB); Edwards, Tony John, Rugby, Warwickshire CV21 1JY (GB)
(74) Representative: Serjeants LLP

(57) **Abstract**

The present invention relates to a power electronic device (1). The device includes a device unit (2) that is located axially between first and second pole pieces (4, 6). A contact pressure adjusting means (8) is located axially between the first and second pole pieces (4, 6). In one arrangement the contact pressure adjusting means (8) includes a support member (10), a pair of disc type springs (16) positioned on the support member (10), and an insulating member (18) positioned around the device unit (2) between the compressible member (16) and the first pole piece (4). An overall contact compression force is applied to the power electronic device (1) by an external contact pressure means forming part of a stack assembly. The compressible member (16) can be compressed until an inner contact member (12) of the support member (10) is in contact with a first surface (2b) of the device unit (2). The contact pressure adjusting means (8) of the power electronic device (1) then applies a device-specific contact compression force to the device unit (2) that is lower than the overall contact compression force applied by the external contact pressure means.

## Description

### Technical Field

The present invention relates to power electronic devices with a device body made of any suitable electronic or semiconductor material, and in particular to power electronic devices that are intended to be used in a stack assembly and optionally immersed in a liquid dielectric.

### Background Art

EP 2161745 discloses a stack assembly where power electronic devices are interspersed and compressed between heatsinks which function as pole pieces. In a preferred arrangement, the power electronic devices have an 'open' construction and are not hermetically sealed in a housing. It will be readily appreciated that such an 'open' power electronic device is differentiated from one having a conventional press pack construction with a hermetically sealed housing which allows all regions of the semiconductor body to be surrounded and permeated by a suitable moderately pressurised dielectric gas, e.g. dry nitrogen.

A contact compression force (clamping force) is applied substantially along the axis of the stack assembly to ensure proper thermal and electrical contact between each power electronic device and adjacent heatsinks (or pole pieces). The contact compression force also ensures proper thermal and electrical contact between any intermediate contact plates of the power electronic device and the device body.

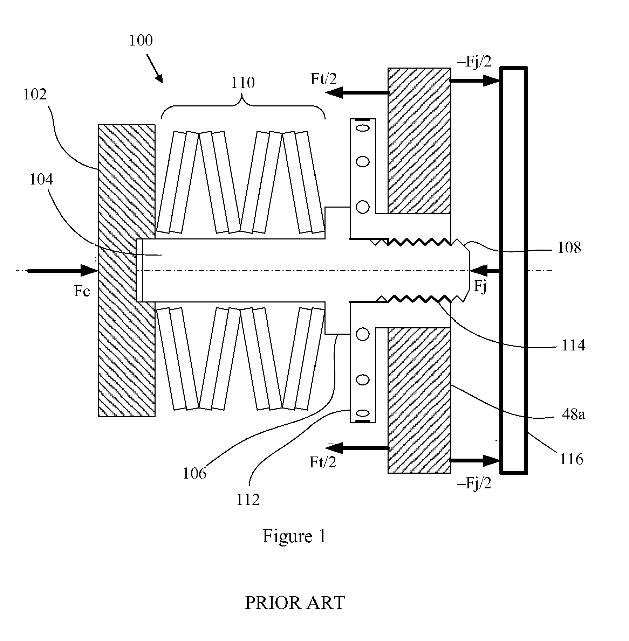

The common contact pressure system (clamping system) of EP 2161745 can set and regulate the contact compression force over the lifetime of the stack assembly and is shown in Figures 1 to 3.

Figure 1 shows the contact pressure system 100 during assembly where external tooling has been secured to allow the contact compression force to be set. The contact pressure system 100 includes a loading pad 102 having a recess for accommodating a loading pin 104. The loading pin 104 incorporates a loading flange 106 and an externally threaded region 108. A compression spring 110 is represented by a series-parallel disc spring system (Belleville washers), but it will be readily appreciated that other suitable spring systems could be used.

A locking collar 112 is internally machined to be a precise fit on the loading pin 104 and the machined interface 114 is highlighted. The locking collar 112 incorporates any suitable rim feature to allow it to be rotated about the loading pin 104. In this case, the locking collar 112 includes a series of angularly spaced holes or openings that are designed to accommodate a G spanner or other suitable tool. The locking collar 112 has a region of circular cross section which has a sliding fit inside an end plate 48a of the stack assembly and a flat pressure surface which bears against a corresponding surface on the end plate.

External tooling incorporates a force setting fixture 116 which applies a compression force Fj to the end of the loading pin 104 and tensile forces -Fj/2 to the extremities of the end plate 48a to preserve the balance of forces. For reasons of clarity, the end plate 48a in Figures 1 to 3 is shown as having only two extremities and two corresponding forces. However, it will be readily appreciated that in practice the end plate 48a may have any convenient number of extremities. The forces can be provided by a calibrated hydraulic jack or any other convenient device.

The loading pad 102 bears against an insulation pad (not shown) which in turn bears against an adjacent end heatsink (or pole piece) to transmit the contact compression force to the stack assembly whilst electrically insulating the stack assembly from the contact pressure system 100 and support structures. A corresponding insulation pad is provided at the other end of the stack assembly between the adjacent end heatsink (or pole piece) and the opposite end plate such that the stack assembly is effectively clamped between the contact pressure system 100 and the opposite end plate whilst electrically insulating the stack assembly from the contact pressure system 100 and support structures.

Figure 1 shows a desired contact compression force Fc applied to the loading pad where Fc = Fj. It can be seen that there is an axial gap or clearance between the corresponding surfaces of the locking collar 112 and the end plate 48a. In order to preserve the balance of forces the corresponding tensile forces Ft/2 are experienced in support rods that pass through the openings in the end plates.

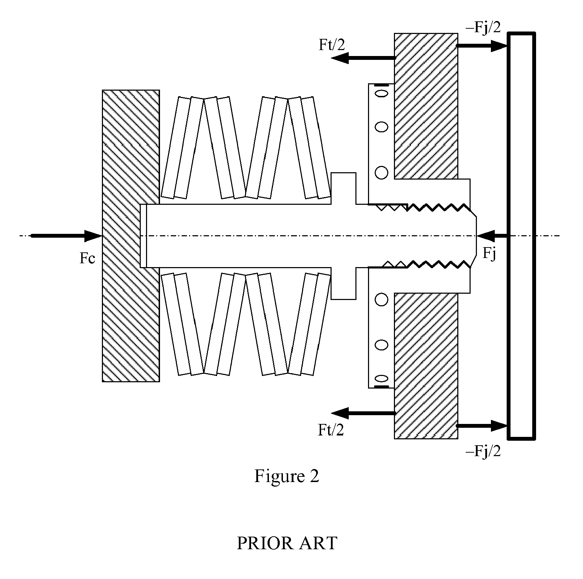

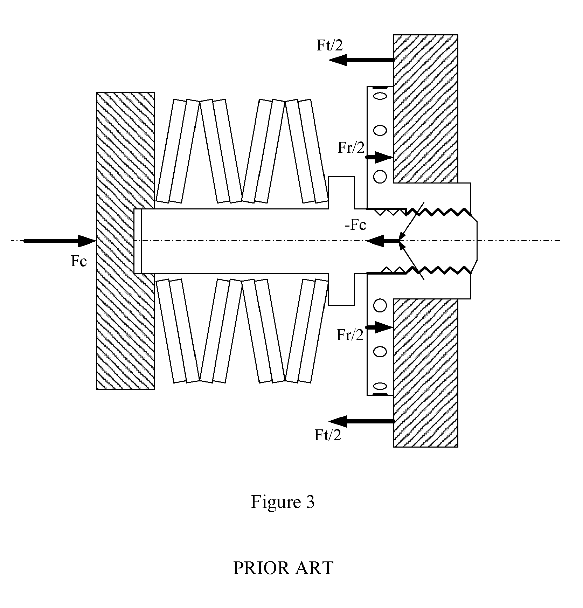

Figure 2 shows the contact pressure system 100 after the locking collar 112 has been rotated in order to close up the axial gap or clearance between the corresponding surfaces of the locking collar and the end plate 48a. At this stage, the thread engagement between the locking collar 112 and the loading pin 104, being nearly rigid, is such that the force setting fixture 116 can be removed (Figure 3) with little effect on the contact compression force Fc. However, in practice the thread engagement is slightly elastic and the clamping force Fc reduces slightly relative to the contact compression force Fj when the force setting fixture 116 is removed. The compression force Fj may be set to make allowance for this elasticity.

After removal of the force setting fixture 116 as shown in Figure 3, reaction forces Fr/2 equivalent to the tensile forces Ft/2 are experienced by the locking collar 112 and these are transferred by the highlighted thread engagement 114 into a compressive force -Fc within the loading pin 104.

The contact compression force will preferably be uniformally distributed over the whole surface of the intermediate cathode and anode contact plates of each power electronic device in the stack assembly.

It will be readily appreciated that a number of effects may combine to influence the contact compression force that is experienced by the power electronic devices in the stack assembly. For example, the following may cause the contact compression force to increase: thermal expansion in the heatsinks (or pole pieces), the intermediate cathode and anode contact plates, the device bodies, and other parts that are held in compression. The following may cause the contact compression force to decrease: thermal expansion or creep in any parts that are held in tension, creep in end plates, plastic flow in the heatsinks (or pole pieces), plastic flow in any locally highly-loaded clamping hardware such as screw threads, seatings for the Belleville washers etc. The effect of friction in the above-described sliding interfaces on the contact compression force must be minimised and in practice this friction will have only a very small influence on the contact compression force (an influence having hysteresis that is governed by the cyclic behaviour of differential thermal expansion).

A stack assembly can include a plurality of power electronic devices of similar size. In this case, each power electronic device will experience substantially the same contact compression force. However, with some stack assembly arrangements it is necessary to have a combination of power electronic devices that are different sizes which means that the power electronic devices will require different contact compression forces. This can sometimes be problematic, particularly for smaller power electronic devices which can be subjected to an excessive contact compression force.

### Summary of the invention

The present invention addresses the problems outlined above and provides a power electronic device comprising:
first and second pole pieces;
a device unit located axially between the first and second pole pieces; and
a contact pressure adjusting means including a compressible member located axially between the first and second pole pieces;
wherein, when an overall contact compression force is applied to the power electronic device by an external contact pressure means (e.g. a clamping system associated with a stack assembly of which the power electronic device forms a part in use), the compressible member is compressed between the first and second pole pieces such that a device-specific contact compression force is applied to the device unit by the first and second pole pieces, the device-specific contact compression force being lower than the overall contact compression force applied by the external contact pressure means.

The compressible member is not compressed between the device unit and one of the first and second pole pieces.

The contact pressure adjusting means can further include an inner contact member that is in contact with a surface of the device unit when the compressible member is compressed, but which is typically spaced apart from the surface when the compressible member is not compressed. The inner contact member acts to limit the amount by which the compressible member is compressed when the overall contact compression force is applied by the external contact pressure means, i.e. no further compression is possible once the inner contact member comes into contact with the device unit.

The inner contact member can be formed as a separate component which is located axially between a surface of the device unit and the respective pole piece. In this case the inner contact member can be formed of any suitable electrically conductive material such as steel, for example. In use, the support member will define an electrically conductive pathway between the respective pole piece and the device unit. The inner contact member makes up the gap between the respective pole piece and the device unit and transfers loading from the respective pole piece to the device unit when the overall contact compression force is applied.

The inner contact member can also be formed as an integral part of a pole piece. In other words, the particular pole piece can be profiled accordingly with a peripheral or radially-outer annular surface and a central or radially-inner part that is upstanding from the annular surface to define the inner contact member.

The compressible member can be located radially outside the inner contact member and optionally has an annular construction. In some arrangements, the inner contact member can be located within a central aperture of an annular compressible member. If the compressible member is made (optionally at least in part) of an insulating material such that it does not provide an electrical pathway then it can be in direct contact with both of the first and second pole pieces. However, if the compressible member is made of an electrically conductive material then an insulating member must normally be located axially between the compressible member and one of the first and second pole pieces. In one arrangement, a first insulating member can be located axially between the compressible member and the first pole piece and a second insulating member can be located axially between the compressible member and the second pole piece.

The compressible member can be a compressible spring incorporating one or more disc type springs (Belleville washers) or similar. Disc type springs have a relatively low spring rate (force per distance compressed) which means that the effect of the dimensional tolerances of the component parts of the contact pressure adjusting means on the device-specific compression force is reduced. However, it will be readily appreciated that in practice any suitable compressible member can be used.

If disc type springs are used then an outer contact member can be used to prevent the springs from damaging the surface of the adjacent pole piece or insulating member. In one arrangement, a first outer contact member can be located axially between the springs and the first pole piece (or interposing insulating member) and a second outer contact member can be located axially between the springs and the second pole piece (or interposing insulating member). Each outer contact member can also act as a load spreader to spread the load applied by the compressible member. It will therefore be readily appreciated that an outer contact member can be used when there is no risk of surface damage just for load spreading purposes.

Each insulating member can be made of a suitable electrically insulating material such as glass-reinforced plastic (GRP) or ceramic, for example. Each insulating member can have an annular construction with a central aperture that is sized to be spaced apart from the outer peripheral edge of the device unit. In general, the component parts of the power electronic device are designed to self-align with suitable recesses, openings or close-tolerant fits. However, it will normally be the case that a gap is provided so that an insulating member does not come into contact with or disturb the outer peripheral edge of the device unit.

Each outer contact member can be made of a suitable material such as steel, for example. If disc type springs are used then each outer contact member can be hardened (e.g. by case or surface hardening) to prevent the springs from damaging its facing surface during use. Each outer contact member can have an annular construction. An outer contact member can optionally be received in a shallow recess provided in the adjacent surface of an insulating member. Such a recess prevents any relative radial movement between the outer contact member and the adjacent insulating member.

In one arrangement, the inner contact member and an outer contact member can be formed as a single, integral, component - referred to below as a support member - with a peripheral or radially-outer part (outer contact member) that acts as a load spreader to spread the load applied by the compressible member and which has an annular surface, and with an central or radially-inner part (inner contact member) that is upstanding from the annular surface. In this arrangement, the radially-inner part can be received in a central aperture of the compressible member. The compressible member is compressed between the first and second pole pieces until the radially-inner part comes into contact with a surface of the device unit. The support member can be made of any suitable electrically conductive material such as steel, for example. In use, the support member will define an electrically conductive pathway between the respective pole piece and the device unit. If disc type springs are used then at least the annular surface of the radially-outer part can be hardened (e.g. by case or surface hardening) to prevent the springs from damaging it during use.

Although the contact pressure adjusting means will normally be concentric with the device unit, this does not necessarily have to be the case.

The device unit of the power electronic device can include a device body or wafer made of any suitable electronic material, including wide bandgap electronic materials such as diamond and silicon carbide, or any suitable semiconductor material that does not have a wide bandgap such as silicon. Diamond is a wide bandgap electronic material that is not conveniently doped to yield P and N type materials with semiconducting properties. Electronic power devices that employ diamond may therefore use other means than semiconducting behaviour to generate carriers. On the other hand, silicon carbide is a wide bandgap material that can be easily doped to facilitate semiconductor behaviour with electron and hole carriers. The device unit can include a whole wafer semiconductor body such as a thyristor, gate turn-off thyristor (GTO), gate commutated thyristor or gate controlled thyristor (GCT), a derivative of these devices (e.g. a dual gated thyristor), or diode. The device unit can also include a die-based semiconductor body such as an insulated-gate bipolar transistor (IGBT). The device body can employ majority carrier or minority carrier type semiconductors, a non-semiconductor power electronic device having two power terminals and optionally at least one control terminal, or an insulator having two power terminals.

In some cases it may be necessary to buffer the device body from the adjacent pole piece or other adjacent component, e.g. an inner contact member or support member, by using intermediate anode and cathode side contact plates or discs. The intermediate contact plates can be made of molybdenum, for example. As used herein the term 'contacting components' refers to the components of the power electronic device that are in direct physical contact with the device body during use, i.e. a pole piece, the inner contact member or support member of the contact pressure adjusting means, or any intermediate contact plates if present. The intermediate contact plates will typically be considered to be part of the device unit, but if considered to be independent components (i.e. not part of the device unit or the contact pressure adjusting means) then any reference herein to a component being in contact with a surface of the device unit should also be taken to include contact with an intermediate contact plate, any ductile metal sheet or foil which can be inserted between a contacting component and the device body etc.

The device body may be of the fully-floating type, i.e. metallised contact surfaces of the device body are not permanently and immovably metallically bonded to the contacting components. It can be preferred that the thickness of the device body is substantially constant and is substantially flat. The contacting surfaces of the contacting components are also preferably flat and smooth in order to maintain the correct distribution of the compression force that is applied to the device body. Alloyed device topologies may be employed where a first side of an alloyed device body is permanently soldered, brazed or otherwise metallically bonded to a corresponding contacting component. A floating contacting component may contact the second side of the alloyed device. It may be necessary to insert a ductile metal sheet or foil between the floating contacting component and the second side of the device body in order to maintain the correct distribution of the compression force. Such a ductile metal sheet or foil can also be inserted between either or both of the contacting components and the device body for a fully-floating type, and will typically be considered to be part of the device unit.

The power electronic device can have an 'open' construction where the device unit is not hermetically sealed in a housing. The power electronic device can also have a conventional press pack construction where the device unit is hermetically sealed in an insulating housing which allows all regions of the device body to be surrounded and permeated by a suitable moderately pressurised dielectric gas, e.g. dry nitrogen.

It is believed that power electronic devices having an 'open' construction will benefit most from being immersed in a liquid dielectric. This is because any spaces or gaps between the various component parts of the power electronic device will be flooded with the liquid dielectric to provide a suitable dielectric environment. The materials used in the power electronic device must be chemically, structurally and dielectrically compatible with the liquid dielectric so that neither the power electronic device nor the liquid dielectric are degraded as a result of their contact. The lack of conventional enclosure parts in a power electronic device having an 'open' construction can also provide significant cost benefits.

The first and second pole pieces may be adapted to carry gate control signals to the device unit by any convenient means. Any gate control signals can be carried to the device unit by any interposing inner contact member or support member positioned between the device unit and the respective pole piece.

The first and second pole pieces can be made of any suitable material such as copper or aluminium, for example.

The pole pieces can function as heatsinks. For example, the pole pieces can be adapted to have a surrounding finned heat exchanger (e.g. radial cooling fins). Such an arrangement is particularly useful if the power electronic device is to be immersed in a liquid dielectric. Movement of the dielectric liquid past the immersed power electronic device will suppress and flush discharge sites clear of the regions of highest field strength and will oppose the formation of larger gas bubbles. The surfaces of the pole pieces may be textured by any convenient process so as to enhance their surface area or to beneficially influence the boundary layer flow with the dielectric liquid and heat exchange behaviour. The pole pieces provide compressive compliance, thermal and electrical connections but additionally provide a short thermal conducting path between the device body and a large wetted metallic heat exchange area. Heat generated during the operation of the power electronic device can therefore be efficiently transferred into the surrounding dielectric liquid.

In use, the power electronic device of the present invention will form part of a stack assembly of the sort described in EP 2161745 where a plurality of power electronic devices are axially aligned and where an overall contact compression force (clamping force) is applied substantially along the axis of the stack assembly to ensure proper thermal and electrical contact between and within each power electronic device. More particularly, present invention further provides a stack assembly comprising:
a power electronic device as described above;
at least one other power electronic device; and
contact pressure means;
wherein the power electronic devices are axially aligned and the contact pressure means applies an overall contact compression force substantially along the axis of the stack assembly.

The overall contact compression force also ensures proper thermal and electrical contact between the device body of each power electronic device and any intermediate contact plates. The contact areas of the two faces of the device body can be suitably metallised to facilitate reliable thermal and electrical contacts. The stack assembly is preferably held in compression by a common or external contact pressure means (clamping system). The contact compression force will be precisely determined and substantially constantly applied by the external contact pressure means substantially along the axis of the stack assembly. The overall contact compression force is such that the asperities or slight projections on adjoining metallic surfaces experience plastic deformation, thereby increasing the inter-metallic contact area as required to reduce thermal contact resistance and electrical contact resistance.

The power electronic device of the present invention will typically be smaller than one or more of the other power electronic devices in the stack assembly, i.e. the device unit has a smaller diameter. The overall contact compression force will typically be precisely determined with reference to the larger power electronic device(s). When the overall contact compression force is applied to the power electronic device of the present invention, the contact pressure adjusting means will reduce the overall contact compression force so that only the device-specific contact compression force is applied to the device unit. More particularly, the first and second pole pieces will move towards each other until the compressible member is at its maximum compression, typically when further compression is prevented by contact between the device unit and the inner contact member or support member. For example, if the external contact pressure means applies an overall contact compression force of 20 kN but the smaller device unit only requires a device-specific contact compression force of 12 kN then the contact pressure adjusting means of the power electronic device will be adapted to effectively absorb 8 kN of the overall contact compression force. Put another way, the compressible member will be designed and constructed so that it exerts an opposite force of 8 kN to reduce the overall contact compression force accordingly. Proper thermal and electrical contact is maintained between the device unit and the contacting components.

By providing a contact pressure adjusting means both the smaller device unit and the device units of other, larger, power electronic devices in the stack assembly can receive the desired contact compression force. In other words, the overall contact compression force that is applied by the external contact pressure means can be adjusted for a particular power electronic device take account of the diameter of the device unit, or any other device-specific contact compression force requirements, so that different power electronic devices can be better accommodated in the same stack assembly. Without such a contact pressure adjusting means the smaller device unit would concentrate the overall contact compression force close to the centre of the longitudinal axis of the stack. This would then require loading pads to spread the contact compression force back out towards the periphery of the stack assembly to ensure that the larger power electronic devices received a uniform clamping force.

The stack assembly is also provided with additional stiffness because the contact pressure adjusting means of the power electronic device provides a larger effective diameter for the smaller device unit that it surrounds.

Power electronic devices within the stack assembly may be configured in any convenient power circuit topology e.g. current source inverter, voltage source inverter, matrix converter and rectifier. Power circuit topologies can be integrated with associated passive components. A complete power circuit topology can be configured within a single stack assembly or may be distributed within any convenient number of stack assemblies. Power electronic devices within the same stack assembly or different stack assemblies may be connected in series or parallel. Power circuit topologies may be configured using any convenient number of stack assemblies and each stack assembly may contain a convenient number of power electronic devices or be of any convenient physical size. A combination of power electronic devices having 'open' and fully housed press pack constructions may be used.

A single stack assembly or a plurality of stack assemblies may form the basic components of either a stand-alone power converter or a power converter that is physically integrated with other equipment (e.g. an electrical machine with integrated power electronics).

Immersing the stack assembly in a liquid dielectric permits highly effective and compact thermal interfaces to be employed without the risk of insulation breakdown. The stack assembly construction can therefore enable the current, voltage and power ratings that may be achieved within a given space to be maximised. The liquid dielectric provides cooling and a dielectric environment in which the stack assembly can be safely operated. Any suitable liquid dielectric may be employed. It will be readily appreciated that the term 'liquid dielectric' is not just intended to cover proprietary liquids that are specifically marketed as such, but any liquid that has a sufficient dielectric withstand. This would include de-ionised water, FLUORINERT and other equivalent perfluorocarbon fluids, mineral transformer oils, silicone transformer oils, synthetic oils and esters, methylene chloride etc. A particularly preferred coolant fluid is a proprietary transformer insulating fluid such as MIDEL and its equivalents. Any coolant fluid will be subject to various environmental and chemical compatibility considerations.

Although the liquid dielectric surrounding the stack assembly can be stationary, it is generally preferred that the liquid dielectric flows past the stack assembly to provide improved cooling, preferably in a direction that is substantially parallel to the axis of the stack assembly.

The present invention further provides a method of adjusting contact pressure applied to a power electronic device comprising:
first and second pole pieces;
a device unit located axially between the first and second pole pieces; and
a contact pressure adjusting means including a compressible member located axially between the first and second pole pieces;
the method comprising the steps of:
   applying an overall contact compression force to the power electronic device; and
   compressing the compressible member between the first and second pole pieces such that a device-specific contact compression force is applied to the device unit by the first and second pole pieces, the device-specific contact compression force being lower than the overall contact compression force applied by the external contact pressure means.

The overall contact compression force can be applied by an external contact pressure means (e.g. a clamping system associated with a stack assembly of which the power electronic device forms a part in use).

### Drawings

Figures 1 to 3 are detail views of a known common pressure contact system that can be used to apply a contact compression force to a stack assembly;
Figure 4 is an exploded view of a power electronic device according to the present invention; and
Figure 5 is a cross section view of the power electronic device of Figure 4.

A power electronic device 1 includes a device unit 2 that includes a device body or wafer that is made of a suitable electronic or semiconductor material as described above. In one example the device unit 2 might be a diode unit.

An upper surface 2a of the device unit 2 is in contact with a first (or upper) copper pole piece 4. In practice, it may be necessary to include an intermediate contact plate (not shown) that is positioned between the device body or wafer of the device unit 2 and the first pole piece 4.

A second (or lower) copper pole piece 6 is provided.

A contact pressure adjusting means 8 is located axially between the first and second pole pieces 4, 6.

The contact pressure adjusting means 8 includes a stepped-profile support member 10 made of steel having a radially-inner contact member 12 that is upstanding from a peripheral or radially-outer part having an annular surface 14. A lower surface 10a of the support member is in contact with an upper surface 6a of the second pole piece 6. It will be readily appreciated that in other arrangements the support member can be formed as two separate components with an inner contact member located axially between the pole piece 6 and the device unit 2, and a separate outer contact member that is similar in construction to the annular load spreading member 22 described below. The outer contact member can be received in a shallow locating recess in a second annular insulating member.

In practice, it may be necessary to include an intermediate contact plate (not shown) between the device body or wafer of the device unit 2 and the inner contact member 12. The support member 10 provides an electrically conductive pathway between the second pole piece 6 and the device unit 2.

The contact pressure adjusting means 8 also includes a pair of disc type springs 16 (Belleville washers) which are located around the inner contact member 12 and are in contact with the radially-outer annular surface 14. The disc type springs 16 define a compressible member. The disc type springs 16 are a close tolerance fit to the cylindrical surface of the inner contact member 12 so that almost no radial movement is permitted.

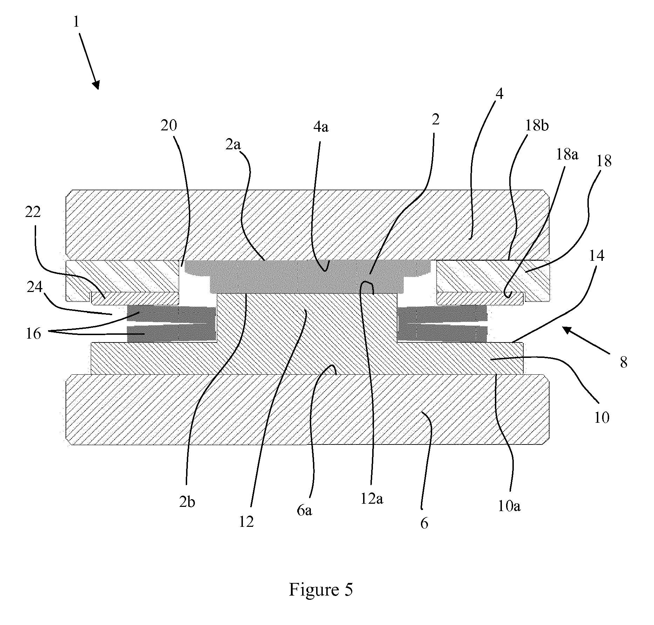

In Figure 5 the contact pressure adjusting means 8 is shown with the disc type springs 16 at maximum compression and an upper surface 12a of the inner contact member 12 is in contact with a lower surface 2b of the device unit 2. Before an overall contact compression force is applied to the power electronic device 1 then the upper surface 12a of the inner contact member 12 will be spaced apart from the lower surface 2b of the device unit 2 and the disc type springs 16 will be uncompressed.

The contact pressure adjusting means 8 also includes an annular insulating member 18 which is positioned around the device unit 2 and spaced apart from its peripheral outer edge by a radial gap 20. The insulating member 18 is made of glass-reinforced plastic (GRP) and ensures that there is no direct electrically conductive pathway between the first and second pole pieces 4, 6. The insulating member 18 includes a shallow locating recess in its lower surface 18a into which an annular load spreading member 22 (or outer contact member) made of hardened steel is received. The load spreading member 22 is in contact with the disc type springs 16. It can be seen in Figure 5 that the disc type springs 16 are located in an annular channel 24 that is defined by the support member 10 (i.e. the annular surface 14 and the cylindrical surface of the inner contact member 12) and the lower surface of the load spreading member 22. In other arrangements, the load spreading member 22 can be omitted so that the disc type springs - or other compression means if used - are in direct contact with the insulating member 18. However, the load spreading member 22 is particularly useful if disc type springs are employed as the compression means because it can prevent the disc type springs from damaging the insulating member. At least the radially-outer annular surface 14 can also be hardened to prevent similar damage to the support member 10.

The upper surface 18b of the insulating member 18 is in contact with a peripheral or radially-outer part of the lower surface 4a of the second pole piece 4.

It can therefore be seen that the disc type springs 16 are compressed between the annular surface 14 of the support member 10 and the load spreading member 22 when a contact compression force is applied to the first and second pole pieces 4, 6 of the power electronic device along its longitudinal axis. The first and second pole pieces 4, 6 can move towards each other to compress the disc type springs 16 until further movement is prevented by the upper surface 12a of the inner contact member 12 coming into contact with the lower surface 2b of the device unit 2 as shown in Figure 5.

The electronic power device 1 will be placed in a stack assembly (e.g. of the sort described generally in EP 2161715) together with other power electronic devices. The power electronic devices are axially aligned and an overall contact compression force (clamping force) is applied along the axis of the stack assembly to ensure proper thermal and electrical contact between and within each power electronic device. The contact compression force is determined by an external contact pressure means, e.g. of the sort shown in Figures 1 to 3 and described generally in EP 2161715.

The stack assembly is immersed in a liquid dielectric such as MIDEL which provides cooling and a dielectric environment. The power electronic device 1 has an 'open' construction and the spaces or gaps between the various component parts of the power electronic device will be flooded with the liquid dielectric. In an alternative arrangement (not shown) the device unit can have a conventional press pack construction with a hermetically sealed housing.

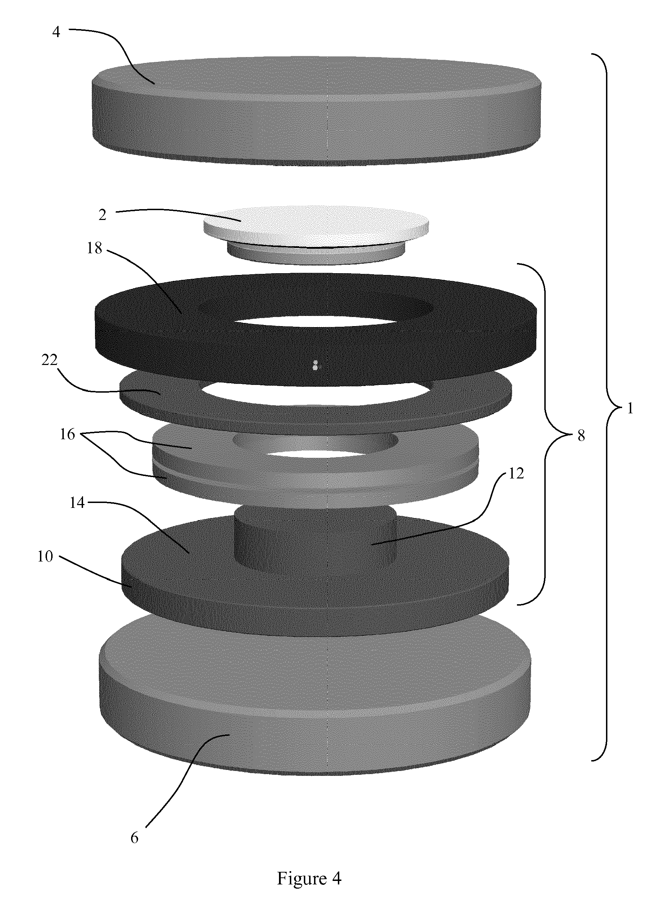

The power electronic device 1 shown in Figures 4 and 5 is smaller than the other power electronic devices in the stack assembly, i.e. the device unit 2 has a smaller diameter.

When the overall contact compression force is applied to the power electronic device 1, and also to the other power electronic devices in the stack assembly, by the external contact pressure means then the disc type springs 16 are compressed and the first and second pole pieces 4, 6 move towards each other until the upper surface 12a of the inner contact member 12 comes into contact with the lower surface 2b of the device unit 2.

The contact pressure adjusting means 8 applies a device-specific contact compression force to the device unit 2, i.e. a contact compression force that is specifically designed to be applied to the device unit and which is lower than the overall contact compression force that is applied by the external contact pressure means. Put another way, the contact pressure adjusting means 8, and more particularly the disc type springs 16 that define the compression member, will reduce the overall contact compression force so that only the lower, device-specific, contact compression force is applied to the device unit 2 of the power electronic device 1.

The other power electronic devices in the stack assembly that do not have a contact pressure adjusting means will continue to experience the overall contact compression force and the proper thermal and electrical contact is maintained throughout the stack assembly. The device-specific contact compression force will also be sufficient to maintain thermal and electrical contact within the power electronic device 1, i.e. so that the asperities or slight projections on adjoining metallic surfaces experience plastic deformation, thereby increasing the inter-metallic contact area as required to reduce thermal contact resistance and electrical contact resistance. This applies to device bodies of the fully-floating type or with alloyed topologies, and where a ductile metal sheet or foil is optionally inserted between the floating contacting component (i.e. the component that is in direct physical contact with the device body) to maintain correct distribution of the compression force.

## Claims

1. A power electronic device comprising:
first and second pole pieces (4, 6);
a device unit (2) located axially between the first and second pole pieces (4, 6); and
a contact pressure adjusting means (8) including a compressible member (16) located axially between the first and second pole pieces (4, 6);
wherein, when an overall contact compression force is applied to the power electronic device by an external contact pressure means, the compressible member (16) is compressed between the first and second pole pieces (4, 6) such that a device-specific contact compression force is applied to the device unit (2) by the first and second pole pieces (4, 6), the device-specific contact compression force being lower than the overall contact compression force applied by the external contact pressure means.

2. A power electronic device according to claim 1, wherein the contact pressure adjusting means (8) further includes an inner contact member (12) that acts to limit the amount by which the compressible member (16) is compressed when the overall contact compression force is applied by the external contact pressure means.

3. A power electronic device according to claim 2, wherein the inner contact member (12) is formed as a separate component which is located axially between a surface (2b) of the device unit (2) and the respective pole piece (6), or is formed as an integral part of a pole piece.

4. A power electronic device according to claim 2 or claim 3, wherein the compressible member (16) is located radially outside the inner contact member (12) and optionally has an annular construction.

5. A power electronic device according to any preceding claim, wherein the contact pressure adjusting means (8) further includes an insulating member (18) located axially between the compressible member (16) and one of the first and second pole pieces (4, 6), the insulating member (18) optionally having an annular construction.

6. A power electronic device according to any preceding claim, wherein the compressible member is a compressible spring incorporating one or more disc type springs (12).

7. A power electronic device according to any preceding claim, wherein the contact pressure adjusting means (8) further includes an outer contact member (22) located axially between the compressible member (16) and one of the first and second pole pieces (4, 6), the outer contact member optionally having an annular construction.

8. A power electronic device according to claim 5, wherein the contact pressure adjusting means (8) further includes an outer contact member (22) located axially between the compressible member (16) and the insulating member (18), the outer contact member optionally having an annular construction.

9. A power electronic device according to claim 8, wherein the outer contact member (22) is located in a recess provided in the adjacent surface (18a) of the insulating member (18).

10. A power electronic device according to claim 1, wherein the contact pressure adjusting means (8) further includes an integral support member (10) that includes an inner contact member (12) that acts to limit the amount by which the compressible member (16) is compressed when the overall contact compression force is applied by the external contact pressure means, and an outer contact member located axially between the compressible member (16) and one of the first and second pole pieces (4, 6).

11. A power electronic device according to claim 10, wherein the support member (10) includes a peripheral part with an annular surface (14) and a central part (12) that is upstanding from the annular surface (14).

12. A stack assembly comprising:
a power electronic device according to any preceding claim;
at least one other power electronic device; and
contact pressure means;
wherein the power electronic devices are axially aligned and the contact pressure means applies an overall contact compression force substantially along the axis of the stack assembly.

13. A stack assembly according to claim 12, being at least partially immersed in a liquid dielectric.

14. A method of adjusting contact pressure applied to a power electronic device comprising: first and second pole pieces (4, 6); a device unit (2) located axially between the first and second pole pieces (4, 6); and a contact pressure adjusting means (8) including a compressible member (16) located axially between the first and second pole pieces (4, 6);
the method comprising the steps of:
applying an overall contact compression force to the power electronic device; and
compressing the compressible member (16) between the first and second pole pieces (4, 6) such that a device-specific contact compression force is applied to the device unit (2) by the first and second pole pieces (4, 6), the device-specific contact compression force being lower than the overall contact compression force applied by the external contact pressure means.

15. A method according to claim 14, wherein the overall contact compression force is applied by an external contact pressure means.
